# EUROPEAN PATENT APPLICATION

(11) **EP 2 680 305 A2**
(43) Date of publication of application: **01.01.2014**
(21) Application number: 12275130.8
(22) Date of filing: 30.08.2012
(51) Int. Cl.: H01L 23/495

(54) **Semiconductor package**

(30) Priority: 29.06.2012 KR 20120070664
(71) Applicant: Samsung Electro-Mechanics Co., Ltd, Suwon, Gyunggi-Do (KR)
(72) Inventor: Jo, Eun Jung, Gyunggi-do (KR); Lim, Jae Hyun, Gyunggi-do (KR); Kim, Tae Hyun, Gyunggi-do (KR); Sohn, Young Ho, Gyunggi-do (KR)
(74) Representative: Potter Clarkson LLP

(57) **Abstract**

There is provided a semiconductor package capable of significantly reducing a size of a power semiconductor package including a power semiconductor device and a control device. The semiconductor package includes a lead frame including a first frame and a second frame; at least one first electronic device mounted on the first frame; a substrate engaged with the second frame and having one surface on which a wiring pattern is formed; and at least one second electronic device mounted on the substrate and electrically connected to the wiring pattern, a portion of the wiring pattern electrically connected to the at least one second electronic device being formed to have a line width smaller than an internal lead of the lead frame.

## Description

### CROSS-REFERENCE TO RELATED APPLICATIONS

This application claims the priority of Korean Patent Application No. 10-2012-0070664 filed on June 29, 2012, in the Korean Intellectual Property Office, the disclosure of which is incorporated herein by reference.

### BACKGROUND OF THE INVENTION

### Field of the Invention

The present invention relates to a semiconductor package, and more particularly, to a semiconductor package capable of significantly reducing a size of a power semiconductor package including a power semiconductor device and a control device.

### Description of the Related Art

As the electronics industry with regard to the manufacturing of electronic devices has been developed and demand for electronic components, such as a power transistor, an insulated-gate bipolar transistor (IGBT), a MOS transistor, a silicon-controlled rectifier (SCR), a power rectifier, a servo driver, a power regulator, an inverter, and a converter, for use in electronic devices, has grown; the need for lightweight, small-sized electronic products having excellent performance has increased.

According to this trend, research into integrating various power semiconductor devices into a single package, as well as manufacturing a control device for controlling power semiconductor devices and a power semiconductor device as a single package, has been recently conducted.

A power semiconductor package according to the related art includes a lead frame, a power semiconductor device mounted on the lead frame, a control device, and a molded unit case formed of resin, or the like.

However, consumer demand for portable electronic devices has rapidly increased in recent times, and thus, small-sized lightweight electronic components for use in portable devices are required.

Accordingly, even though research into a method of reducing a size of a semiconductor device itself has been undertaken to allow for a reduction in the size of electronic components, this method is somewhat limited. Thus, irrespective of the size of the semiconductor device, a method of reducing a size of a semiconductor package through an efficient arrangement of the semiconductor device and conducting wires, etc. is required.

### [Related Art Document]

Korean Patent Laid-Open Publication No. 2002-0095053

### SUMMARY OF THE INVENTION

An aspect of the present invention provides a semiconductor package having a significantly reduced size.

Another aspect of the present invention provides a semiconductor package in which a control device is mounted using a separate control substrate.

According to an aspect of the present invention, there is provided a semiconductor package including: a lead frame including a first frame and a second frame; at least one first electronic device mounted on the first frame; a substrate engaged with the second frame and having one surface on which a wiring pattern is formed; and at least one second electronic device mounted on the substrate and electrically connected to the wiring pattern, wherein a portion of the wiring pattern electrically connected to the at least one second electronic device is formed to have a line width smaller than an internal lead of the lead frame.

The at least one first electronic device may be a power semiconductor device, and the at least one second electronic device may be a control device.

The control device may be electrically connected to the wiring pattern by wire bonding or flip chip bonding.

The control device and the power semiconductor device may be disposed horizontally.

The semiconductor package may further include: a molding unit encapsulating the electronic devices.

The electronic device may be mounted on one surface of the substrate, and another surface of the substrate may be exposed to the outside of the molding unit.

The second frame may be provided with a step down formed thereon, and the substrate may be engaged with the step down.

The second frame may be engaged with the substrate by solder bonding.

According to another aspect of the present invention, there is provided a semiconductor package including: a lead frame including a first frame and a second frame; a first substrate engaged with the first frame and having one surface on which a first wiring pattern is formed; a second substrate engaged with the second frame and having one surface on which a second wiring pattern is formed; and a plurality of electronic devices mounted on the first substrate and the second substrate; wherein the first wiring pattern and the second wiring pattern are formed to have different line widths and thicknesses.

The second wiring pattern may be formed to have a line width smaller than the first wiring pattern.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a schematic cross-sectional view of a semiconductor package according to an embodiment of the present invention;
FIG. 2 is a plan view of the semiconductor package in direction A of FIG. 1;
FIG. 3 is a schematic plan view of a structure in which a control device is mounted according to the related art;
FIG. 4 is a schematic plan view of a structure in which a control device is mounted according to an embodiment of the present invention;
FIG. 5 is a schematic cross-sectional view of a semiconductor package according to another embodiment of the present invention; and
FIG. 6 is a schematic cross-sectional view of a semiconductor package according to another embodiment of the present invention.

### DETAILED DESCRIPTION OF THE EMBODIMENTS

The terms and words used in the present specification and claims should not be interpreted as being limited to typical meanings or dictionary definitions, but should be interpreted as having meanings and concepts relevant to the technical scope of the present invention based on the rule according to which an inventor can appropriately define the concept of the term to appropriately describe methods he or she knows for carrying out the invention. Therefore, the configurations described in the embodiments and drawings of the present invention are appropriate embodiments but do not represent all of the technical spirit of the present invention. Thus, the present invention should be construed as including all the changes, equivalents, and substitutions included in the spirit and scope of the present invention at the time of filing this application.

Hereinafter, embodiments of the present invention will be described in detail with reference to the accompanying drawings. Here, it is noted that like reference numerals denote like elements throughout the drawings. Moreover, detailed descriptions related to well-known functions or configurations will be ruled out in order not to unnecessarily obscure the subject matter of the present invention. Based on the same reason, it is to be noted that some components shown in the drawings are exaggerated, omitted or schematically illustrated, and the size of each component does not exactly reflect its real size.

Hereinafter, embodiments of the present invention will be described in detail with reference to the accompanying drawings.

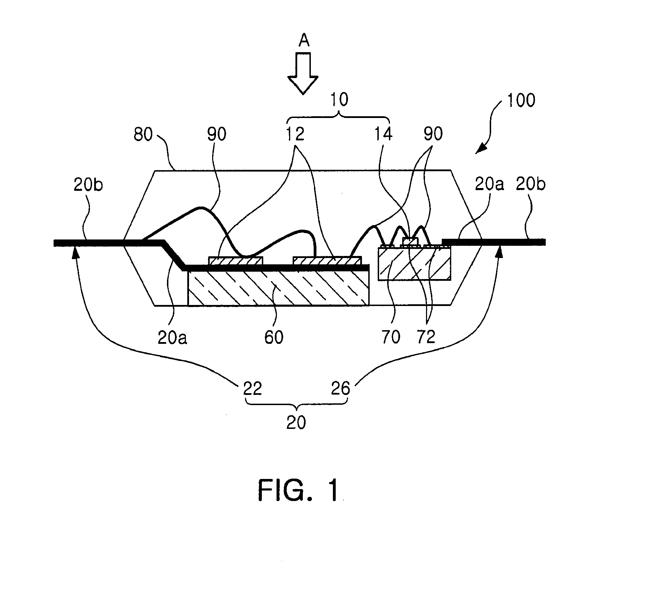

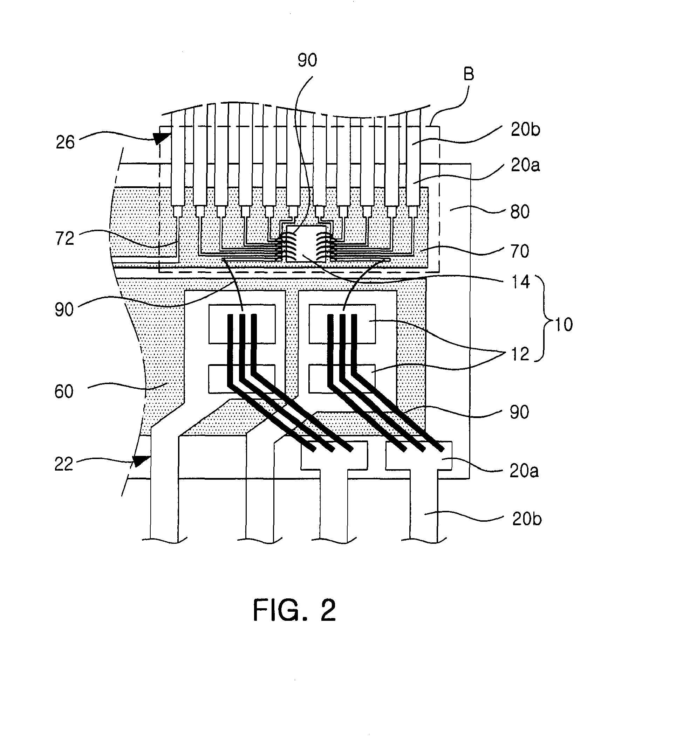

FIG. 1 is a schematic cross-sectional view of a semiconductor package according to an embodiment of the present invention. FIG. 2 is a plan view of the semiconductor package in direction A of FIG. 1, in which a part of a molding unit is removed.

Referring to FIGS. 1 and 2, a semiconductor package 100 according to the present embodiment may include an electronic device 10, a lead frame 20, first and second substrates 60 and 70, and a molding unit 80.

The electronic device 10 may include various devices such as a passive device and an active device, etc. In particular, the electronic device 10 according to the present embodiment may include at least one first electronic device 12 (for example, a power semiconductor device) and at least one second electronic device 14 (for example, a control device).

In this regard, the power semiconductor devices 12, the first electronic devices 12, may be power circuit devices for power conversion or power control to control power, such as a servo driver, an inverter, a power regulator, a converter, etc.

For example, the power semiconductor devices 12 may include be a power MOSFET, a bipolar junction transistor (BJT), an insulated-gate bipolar transistor (IGBT), or a diode, or a combination thereof. That is, in the present embodiment, the power semiconductor devices 12 may include all of or portions of the above-described devices.

Also, each of the two power semiconductor devices 12 may be the IGBT and the diode. Also, a power semiconductor device package including six pairs each including the IGBT and the diode as a pair may be implemented. However, this is one example, and the present invention is not limited thereto.

The power semiconductor devices 12 may be attached to one surface of a first substrate 60 that will be described later by means of a bonding member (not shown). Here, the bonding member may be conductive or non-conductive. For example, the bonding member may be formed by plating or a conductive paste or a tape. Also, a solder, a metal epoxy, a metal paste, a resin-based epoxy, or a bonding tape having excellent heat resistance, etc. may be used as the bonding member.

The control device 14 may be electrically connected to the power semiconductor devices 12 through a bonding wire 90, so as to operations of the power semiconductor devices 12. The control device 14 may be, for example, a microprocessor, and may further include a passive device such as a resistor, an inverter, or a condenser, or an active device such as a transistor.

Meanwhile, one or a plurality of the control devices 14 may be disposed with respect to the one power semiconductor device 12. That is, types and the number of the control devices 14 may be appropriately selected with respect to types of and the number of the power semiconductor devices 12.

As described above, the semiconductor package 100 according to the present embodiment may be the power semiconductor package 100 including the power semiconductor devices 12 and the control device 14 for controlling the power semiconductor devices 12.

Also, in the present embodiment, the power semiconductor devices 12 and the control device 14 are not disposed in a vertically laminated shape but are disposed horizontally. Accordingly, the semiconductor package 100 is formed to have a horizontal length longer than a vertical length (i.e. a thickness).

The lead frame 20 is configured to include a plurality of leads that may be classified into a plurality of external leads 20b connected to an external substrate (not shown) and a plurality of internal leads 20a connected to the electronic device 10. That is, the external leads 20b may indicate a portion thereof exposed to the outside of the molding unit 80, and the internal leads 20a may indicate a portion thereof disposed in an inner portion of the molding unit 80.

Also, the lead frame 20 may include a first frame 22 electrically connected to the power semiconductor devices 12 and a second frame 26 electrically connected to the control devices 14. A step down in which the internal leads 20a are curved to be stepped may be formed in at least one of the first and second frames 22 and 26.

In the present embodiment, the step down is formed in the internal leads 20a of the first frame 22 connected to the power semiconductor devices 12. However, the present invention is not limited thereto. The step down may be configured to be formed in the second frame 26 or both the first frame 22 and the second frame 26 as necessary.

The power semiconductor devices 12 are mounted on one surface of the first frame 22. The power semiconductor devices 12 are electrically connected to the internal leads 20a of the first frame 22 through the bonding wire 90.

The second frame 26 is electrically connected to the control devices 14 by means of a second substrate 70. That is, the control device 14 is not directly mounted on the second frame 26 but is mounted on the second substrate 70, and is electrically connected to the internal leads 20a of the second frame 26 through a second wiring pattern 72 of the second substrate 70 and the bonding wire 90.

The first and second substrates 60 and 70 may be printed circuit board (PCB), ceramic substrates, pre-molded substrates, direct bonded copper (DBC) substrates, or conductive substrates provided by the lead frame 20.

In particular, the first and second substrates 60 and 70 according to the present embodiment may be insulated metal substrates (IMSs).

The first substrate 60 is engaged with the first frame 22. One surface of the first substrate 60 is bonded to another surface of the first frame 22, and another surface thereof is exposed to the outside of the molding unit 80 that will be described later.

Meanwhile, although not shown, a first wiring pattern may be formed in one surface of the first substrate 60. However, in the present embodiment, the first wiring pattern is only used to bond the power semiconductor devices 12 to the first substrate 60 and is not used to electrically connect the power semiconductor devices 12 to the first substrate 60. Thus, the power semiconductor devices 12 may be easily bonded without the first wiring pattern, and thus the first wiring pattern is omitted here.

The second substrate 70 is spaced apart from the first substrate 60 by a predetermined distance and is engaged with the second frame 26. A second wiring pattern 72 is formed in one surface of the second substrate 70.

The second wiring pattern 72 may use a general layer forming method, for example, chemical vapor deposition (CVD) and physical vapor deposition (PVD) or may be formed by electrolysis plating or electroless plating. Also, the second wiring pattern 72 may include a conductive material such as metal. For example, the second wiring pattern 72 may include aluminum, an aluminum alloy, copper, a copper alloy, or a combination thereof.

Also, the control device 14 is mounted on one surface of the second substrate 70 and is electrically connected to the second wiring pattern 72.

In this regard, a line width of the second wiring pattern 72 may be a very narrow fine pattern. More specifically, the line width of the second wiring pattern 72 may be narrower within a range by which bonding of the bonding wire 90 is possible.

Meanwhile, although the electronic devices 10 are electrically connected to the second wiring pattern 72 through the bonding wire 90 in the present embodiment, the present invention is not limited thereto.

That is, the control device 14 and the second substrate 70 are electrically connected through various applications, for example, flip chip bonding or a solder ball.

The bonding wire 90 may be a metal material, for example, aluminum (Al), gold (Au), or an alloy thereof. Also, to bond the electronic devices 10 to the second wiring pattern 72 through the bonding wire 90, each of the electronic devices 10 and the second wiring pattern 72 may include a connection unit such as a general connection pad.

The molding unit 80 allows for another surface of the first substrate 60 to be exposed, and encapsulates the first substrate 60, the power semiconductor devices 12, the second substrate 70, the control device 14, and a part (i.e. the internal leads 20a) of the first and second frames 22 and 26).

The molding unit 80 is formed to cover and encapsulate the electronic devices 10 and the internal leads 20a of the lead frame 20 bonded to the electronic devices 10 to protect the electronic devices 10 from an external environment. Also, the molding unit 80 surrounds the electronic devices 10 to fix the electronic devices 10, thereby safely protecting the electronic devices 10 from external shocks.

The molding unit 80 is formed to allow for another surface of the first substrate 60 to be exposed to the outside. That is, the molding unit 80 may be formed to cover a portion of the first substrate 60 other than the whole of the first substrate 60.

The molding unit 80 may be formed of an insulating material. In particular, a material having relatively high thermal conductivity such as silicon gel, thermally conductive epoxy, polyimide, etc. may be used.

Meanwhile, although not shown, a heat sink (not shown) may be attached to an exterior surface of the molding unit 80, in particular, another surface of the first substrate 60, in order to effectively dissipate heat. The heat sink may be attached using a high temperature tape or a high temperature solder, etc. and is completely exposed to the outside of the semiconductor package 100.

In the semiconductor package 100 according to the present embodiment, the control device 14 is electrically connected to the internal leads 20a of the second frame 26 by means of the second substrate 70.

More specifically, a thickness and a line width of the second wiring pattern 72 formed in the second substrate 70 are smaller than the internal leads 20a of the lead frame 20.

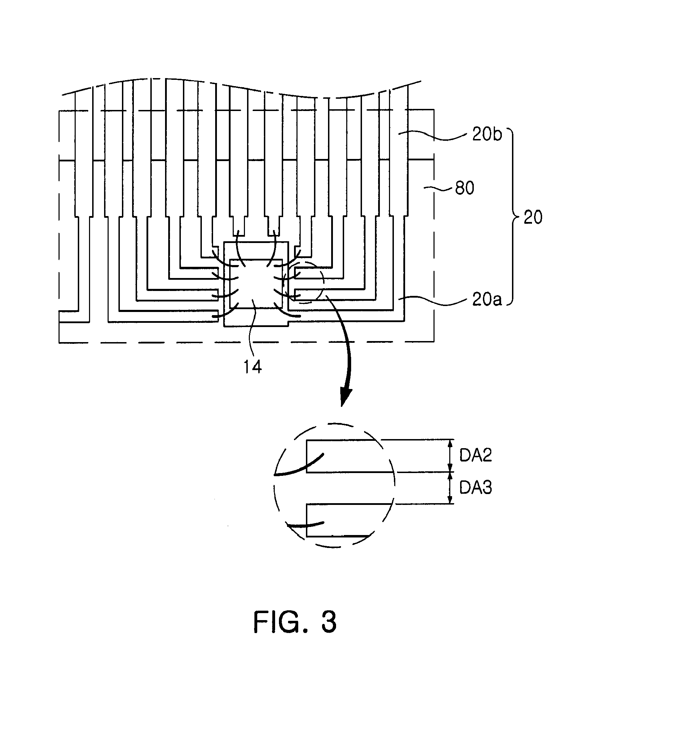

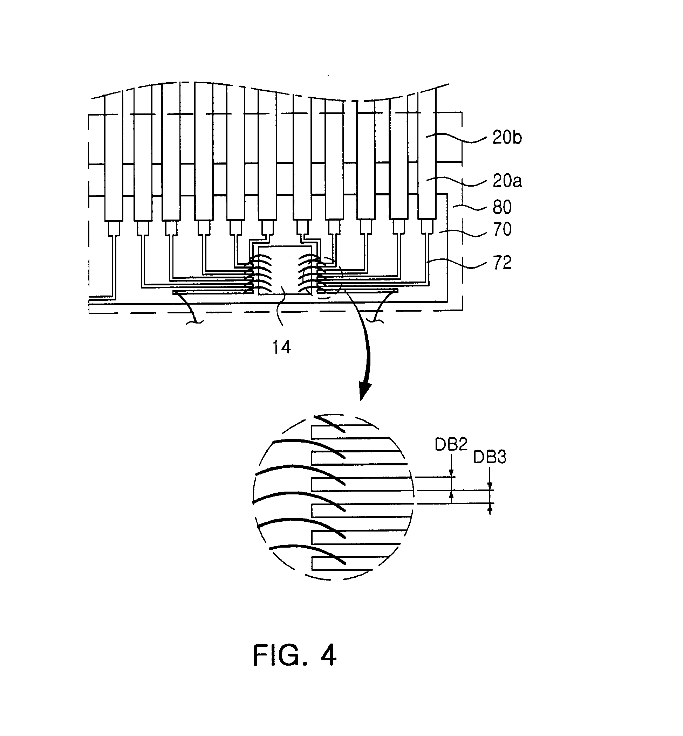

FIG. 3 is a schematic plan view of a structure in which a control device is mounted according to the related art. FIG. 4 is a schematic plan view of a structure in which a control device is mounted according to an embodiment of the present invention, in which part B of FIG. 2 is magnified.

Referring to FIG. 3, in a semiconductor package according to the related art, the control device 14 is directly mounted on the lead frame 20 without using the second substrate 70 (of FIG. 4).

Since the lead frame 20 generally needs to maintain rigidity, it may be difficult to manufacture the lead frame 20 below a predetermined thickness (for example, 0.3 mm). Thus, the internal leads 20a of the lead frame 20 need to allow for thicknesses (for example, 0.3 mm) and line widths DA2 (for example, 0.3 mm equal to the thicknesses, or more) to be maintained as a threshold or more. Also, spaced distances between the internal leads 20a need to be maintained as a threshold DA2 (for example, 0.35 mm) or more.

In this case, as shown in FIG. 3, the internal lead 20a connected to the one control device 14 needs to have a width of at least 0.65 mm or more including a line width thereof and a spaced distance between the internal leads.

As such, the semiconductor package according to the related art is limited to reducing a space for connecting the control device 14 to the lead frame 20 due to its structure limitation.

However, as shown in FIG. 4, the semiconductor package 100 uses the second wiring pattern 72 formed in the second substrate 70 other than the lead frame 20.

The second wiring pattern 72 may be formed to have a relatively very narrow line width as occasions demand. In FIG. 4, when the same control device 14 as in FIG. 3 is used, the line width DB2 is 0.05 mm, and the spaced distance DB3 between patterns is 0.05 mm.

In a case in which the second substrate 70 in which the second wiring pattern 72 having a relatively very narrow line width as described above is formed is used, a space for electrically connecting the control device 14 and the lead frame 20 may be significantly reduced as compared to the semiconductor package according to the related art only using the lead frame 20.

As described above, in the semiconductor package 100 according to the present embodiment, the control device 14 as well as the power semiconductor devices 12 is mounted on a separate substrate, and the control device 14 is not directly connected to the lead frame 20 but is connected to the second wiring pattern 72 formed in the second substrate 70.

Therefore, a space used to connect the control device 14 and the lead frame 20 becomes smaller, thereby reducing a horizontal length of the semiconductor package 100. Thus, the whole size of the semiconductor package 100 may be reduced.

Meanwhile, a semiconductor package according to the present invention is not limited to the above-described embodiment and may have various applications as occasions demand.

The whole constructions of embodiments described below are similar to that of the above-described embodiment except for a second substrate on which a control device is mainly mounted or a configuration of a second frame to which the second substrate is connected. Thus, a detailed description of the same construction as that of the above-described embodiment is omitted here, and differences therebetween will now be described in more detail.

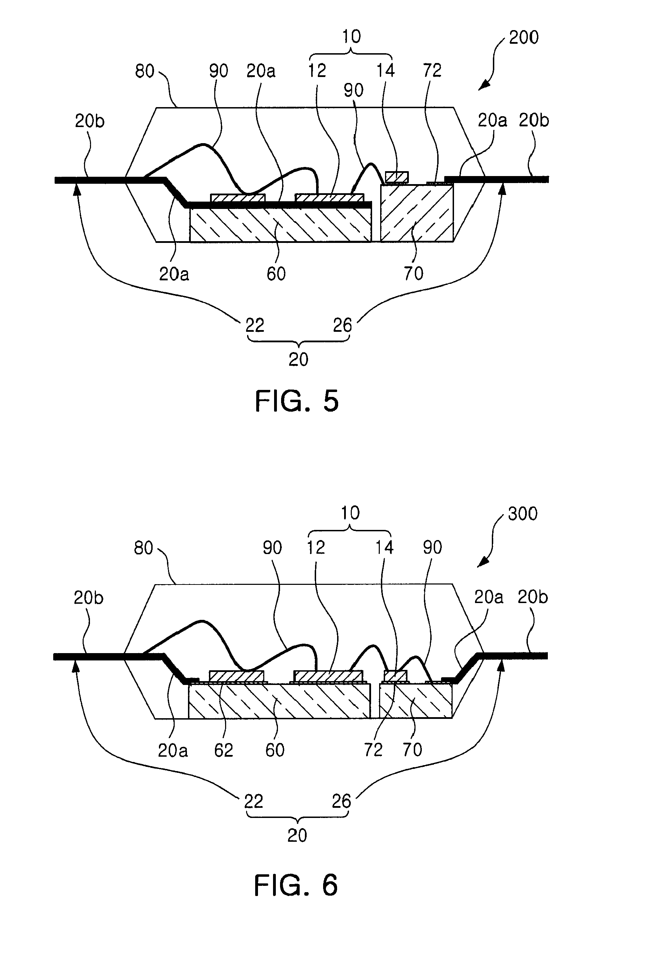

FIG. 5 is a schematic cross-sectional view of a semiconductor package according to another embodiment of the present invention.

In a semiconductor package 200 according to the present embodiment, another surface of the second substrate 70 is configured to be exposed to the outside of the molding unit 80 as in the first substrate 60.

In a case in which another surface of the second substrate 70 is exposed to the outside of the molding unit 80, heat generated by the control device 14 may be easily dissipated to the outside, thereby increasing heat dissipation efficiency.

Also, the control device 14 is mounted on the second substrate 70 through flip chip bonding other than using the bonding wire 90.

As described above, a semiconductor package according to embodiments of the present invention may be applied in various ways.

FIG. 6 is a schematic cross-sectional view of a semiconductor package according to another embodiment of the present invention.

In a semiconductor package 300 according to the present embodiment, a step down is also formed in the second frame 26, and the second substrate 70 is engaged with a location of the second frame 26 in which the step down is formed.

As such, in a case in which the step down is formed in the second frame 26, the control device 140 is disposed adjacent to the outside, thereby increasing a heat dissipation effect.

Also, in the semiconductor package 300 according to the present embodiment, the power semiconductor device 12 is mounted on one surface of the first substrate 60 other than the first frame 22 as in the control device 14.

In this case, the first wiring pattern 62 is formed in one surface of the first substrate 60. In this regard, the first wiring pattern 62 may be configured in the same manner as the second wiring pattern 72 described above.

Also, the power semiconductor devices 12 may be electrically connected to the first wiring pattern 62 of the first substrate 60 by using the bonding wire 90 or through flip chip bonding. As shown in FIG. 6, the power semiconductor devices 12 may be electrically connected to the internal leads 20a of the first frame 22 through the bonding wire 90.

In this case, in the semiconductor package 300 according to the present embodiment, the first and second wiring patterns 62 and 72 of the first substrate 60 and the second substrate 70 are formed in different ways. That is, the first wiring pattern 62 formed in the first substrate 60 may be formed to have a thickness and a line width greater than those of the second wiring pattern 72 of the second substrate 70.

This is because the power semiconductor devices 12 generate heat more than the control device 14, the power semiconductor devices 12 need to use a relatively thick wiring pattern other than a fine wiring pattern as in the control device 14. Thus, in a case in which the power semiconductor devices 12 are electrically connected to the first wiring pattern 62, the first wiring pattern 62 may be formed to have a large line width (for example, 0.3 mm or more) corresponding to that of the internal leads 20a of the lead frame 20.

As set forth above, with a semiconductor package according to the embodiments of the invention, control devices as well as power semiconductor devices may be mounted on a separate substrate, and the control devices may be electrically connected to a wiring pattern formed in the substrate other than a lead frame.

Therefore, compared to a semiconductor package according to the related art that uses only a lead frame without a substrate for a control device, a space used to electrically connect the control devices and the lead frame may be reduced, thereby reducing a whole size of the semiconductor package.

While the present invention has been shown and described in connection with the embodiments, it will be apparent to those skilled in the art that modifications and variations can be made without departing from the spirit and scope of the invention as defined by the appended claims.

## Claims

1. A semiconductor package comprising:
a lead frame including a first frame and a second frame;
at least one first electronic device mounted on the first frame;
a substrate engaged with the second frame and having one surface on which a wiring pattern is formed; and
at least one second electronic device mounted on the substrate and electrically connected to the wiring pattern,
a portion of the wiring pattern electrically connected to the at least one second electronic device being formed to have a line width smaller than an internal lead of the lead frame.

2. The semiconductor package of claim 1, wherein the at least one first electronic device is a power semiconductor device, and the at least one second electronic device is a control device.

3. The semiconductor package of claim 2, wherein the control device is electrically connected to the wiring pattern by wire bonding or flip chip bonding.

4. The semiconductor package of claim 2, wherein the control device and the power semiconductor device are disposed horizontally.

5. The semiconductor package of claim 1, further comprising: a molding unit encapsulating the electronic devices.

6. The semiconductor package of claim 5, wherein the electronic device is mounted on one surface of the substrate, and another surface of the substrate is exposed to the outside of the molding unit.

7. The semiconductor package of claim 1, wherein the second frame is provided with a step down formed thereon, and the substrate is engaged with the step down.

8. The semiconductor package of claim 1, wherein the second frame is engaged with the substrate by solder bonding.

9. A semiconductor package comprising:
a lead frame including a first frame and a second frame;
a first substrate engaged with the first frame and having one surface on which a first wiring pattern is formed;
a second substrate engaged with the second frame and having one surface on which a second wiring pattern is formed; and
a plurality of electronic devices mounted on the first substrate and the second substrate;
the first wiring pattern and the second wiring pattern being formed to have different line widths and thicknesses.

10. The semiconductor package of claim 9, wherein the second wiring pattern is formed to have a line width smaller than the first wiring pattern.
